# EUROPEAN PATENT SPECIFICATION

(11) **EP 3 339 245 B1**
(45) Date of publication and mention of the grant of the patent: **01.06.2022**
(21) Application number: 16206805.0
(22) Date of filing: 23.12.2016
(51) Int. Cl.: B82Y 10/00, H01L 29/66, H01L 29/775, H01L 29/06

(54) **METHOD FOR FORMING HORIZONTAL NANOWIRES AND DEVICES MANUFACTURED THEREOF**
VERFAHREN ZUR FORMUNG HORIZONTALER NANODRÄHTE UND DARAUS HERGESTELLTE VORRICHTUNGEN
PROCÉDÉ DE FORMATION DE NANOFILS HORIZONTAUX ET DISPOSITIFS OBTENUS SELON CE PROCÉDÉ

(43) Date of publication of application: 27.06.2018
(73) Proprietor: IMEC vzw, 3001 Leuven (BE)
(72) Inventor: Chan, Boon Teik, 3001 Leuven (BE); Armini, Silvia, 3001 Leuven (BE); Camerotto, Elisabeth, 3001 Leuven (BE); Tao, Zheng, 3001 Leuven (BE)
(74) Representative: Patent Department IMEC

(56) References cited:
- WO-A1-2015/094301
- CN-A- 104 253 048
- US-A1- 2013 075 797
- US-A1- 2014 097 502
- US-A1- 2014 273 423
- US-B1- 9 425 293

## Description

### Technical field of the invention

The present invention is related to the field of semiconductor devices. More specifically, it is related to a method for forming horizontal nanowires and devices manufactured thereof.

### Background of the invention

In the past decade, semiconductor industry changed the transistor design by moving from planar CMOS to fin-type field effect transistors (Fin-FETs). However, as the fin width has continued to decrease in an effort to enable ultimate CMOS scaling, undesirable variability and mobility in the channel have become a challenge due to the result of decreasing channel width. One way to overcome this problem, has been the introduction of a new transistor architecture called the gate-all-around field effect transistor (GAA-FET) . In a GAA-FET design, the gate is placed on all sides of the channel, and it incorporates at least one horizontal nanowire, whereby the nanowires forming the channels are suspended as they run from the source to the drain. This provides better gate control and electrostatics than finFETs thereby enabling further gate length scaling.

Despite these advantages, there are requirements as well as challenges associated with the making of horizontal nanowires. The ultimate goal for GAA-FET is to have at least three nanowires in parallel in order to increase driving current, to keep the CD scaling within 5 to 7 nm and to provide same width across all the nanowires for better performance. The challenges thus, lie in the making of the nanowires to satisfy these requirements.

Horizontal nanowires are typically made by removing a sacrificial semiconductor material selectively from a multilayer stack containing alternating layers of this sacrificial material and a semiconductor nanowire material. Selective removal can be done by using selective wet etching. US 2013/0161756 A1 discloses selectively etching the sacrificial SiGe layers with a wet etch that selectively removes the SiGe but does not remove the silicon nanowire structures. Selective removal can also be done by using selective dry plasma etching, whereby selective oxidation is done a priori.

Although these known techniques help in the forming of horizontal nanowires, they do not guarantee satisfying the requirement of CD being scaled to 5 to 7 nm and/or providing the same CD across all the nanowires formed. Thus, although selective removal would lead to the formation of nanowires, it may not lead to the satisfaction of the above requirements. Furthermore, the selectivity between the alternating layers of the semiconductor material to be sacrificed and the semiconductor material to be made into nanowires will suffer from non-uniformities between the incoming wafers having such multi-layer stacks. The selective etch process while producing nanowires may not be able to meet the above requirements.

There is, therefore, a need in the art for methods that enable the formation of horizontal nanowires that are suitable for manufacturing GAA-FETs without jeopardizing device performance while keeping up with the scaling efforts of CMOS manufacturing.

### Summary of the Invention

It is an object of the present invention to provide efficient and simple methods to form horizontal nanowires. It is a further object of the invention to form gate-all-around field effect transistor(GAA-FET).

The above objective is accomplished by a method according to the present invention.

The present invention relates to a method according to claim 1. Advantageous embodiments are set out in the dependent claims.

It is an advantage of the embodiments of the present invention that the method allows for formation of horizontal nanowires, particularly more than two horizontal nanowires in a sequential way, thereby making the formation of such nanowires independent of the limitations of selective etching of the first material with respect to the second material.

The inventors have found out that forming a sacrificial layer on the remaining portion that follows the selective removal of the first material up to the moment that a horizontal nanowire becomes suspended and the provision of a cladding layer, selectively, on the suspended horizontal nanowire allows for sequential formation of horizontal nanowires.

It is an advantage of the embodiments of the present invention that the method allows for forming more than two horizontal nanowires.

The provision of the cladding layer avoids any further change in the size of the already formed horizontal nanowire during the formation of the subsequent horizontal nanowires.

Thus, it is an advantage of embodiments of the present invention that the method allows for optimizing and further preserving the (desired) diameter or referred to as the critical dimension (CD) of the horizontal nanowires during their formation.

Thus, it is further an advantage of embodiments of the present invention that the method allows for forming horizontal nanowires, particularly more than two horizontal nanowires, having the substantially the same (desired) diameter.

It is an advantage of embodiments of the present invention that the method allows for formation of horizontal nanowires starting from a fin structure, wherein the height and the profile of the fin becomes less of a challenge for obtaining horizontal nanowires, particularly more than two horizontal nanowires having substantially the same (desired) diameter.

It is an advantage of embodiments of the present invention that the method is compatible with CMOS manufacturing.

In embodiments, the substrate may be rotated during the formation of the sacrificial layer. This rotation may be performed along a vertical axis perpendicular to the substrate.

Advantageously, by rotating the substrate, the sacrificial layer will be homogeneously distributed over the surface. Furthermore, rotation allows for controlling the thickness of the sacrificial layer by adjusting the rotation speed. Homogeneously distributed sacrificial layer with a controlled thickness allows for uniform coverage of the remaining portion. Uniform coverage of the remaining portion allows for the provision of the cladding layer over the complete surface of the suspended horizontal nanowire.

According to the invention, the sacrificial layer is a spin-on material and is self-planarizing.

A spin-on material that is self-planarizing is advantageous due to the fact that it allows for uniform coverage of the remaining portion without creation of topography. Absence of topography has the advantage that material removal processes, such as etch back, in order to provide the required thickness may be avoided. Avoiding the use of material removal processes allows for preventing the modification of the (desired) diameter of the already formed horizontal nanowire by being subjected chemicals during the etch-process.

In embodiments, the sacrificial layer may be formed as a spin-on carbon layer (SoC).

It is advantageous to form the sacrificial layer as a SoC layer since it allows easy removal without damaging the masked part of the protruding portion. The mask of the masked part of the protruding portion may comprise interlayer dielectric in contact with a dielectric spacer material. The damaging of the interlayer 5 dielectric and the dielectric spacer material may result in degradation of the device performance since it will result in exposure of the gate electrode leading to electrical shorting of the gate electrode with the source or the drain region after establishing the electrical contact.

According to the invention, the selective removal of the first material is cyclic and comprises oxidizing the first material and the second material and performing an etching process. Parameters of the etching process may be chosen to remove the oxide of the first material faster than the oxide of the second material.

Advantageously, such a cyclic selective removal allows for removal of the first material with respect to the second material with improved selectivity.

In embodiments, the etching process may be a dry plasma etching process.

In embodiments, the cladding layer may be a metal.

It is advantageous to have a metal cladding since it allows for protection of the horizontal nanowire over which it is provided during the removal of the sacrificial layer. This ensures the preservation of the size of the horizontal nanowire.

In embodiments, this metal may be nickel, cobalt or ruthenium.

In preferred embodiments, this metal may be nickel.

In alternative embodiments, this cladding layer may be a metal oxide.

This metal oxide may be a high-k dielectric material. This high-k dielectric material may be aluminum oxide, hafnium oxide, zinc oxide, zirconium oxide or titanium oxide.

Metal oxide cladding layer has the advantage that it is not affected by the cyclic selective removal.

In embodiments, the selective provision of the cladding layer may comprise performing an electro-less deposition or an atomic layer deposition.

By performing the electro-less or atomic layer deposition, advantageously, the thickness of the cladding layer may be better controlled. Better control of the thickness of the cladding layer may result in preservation of the size of the horizontal nanowire during the removal of the sacrificial layer.

Furthermore, electro-less deposition is advantageous due to the fact that it is a low-temperature process such that it can be carried out at a temperature in the range of room temperature to 70 °C. Furthermore, it provides selective deposition.

In embodiments, the first material may comprise Si and Ge and the second material may comprise Si.

In embodiments, the first material may be SiGe and the second material may be Si.

In embodiments, the first material may comprise Si and the second material may comprise Si and Ge.

In embodiments, the first material may be Si and the second material may be SiGe.

In embodiments, the selective removal may comprise performing a wet etching process.

In embodiments, the wet etching process may be done by using a wet etchant comprising hydrogen chloride.

In embodiments, the wet etchant may consist of water and hydrogen chloride.

In embodiments, where the selective removal may comprise performing this wet etching process, a layer of a first material comprising a binary Group III-V material may be stacked alternately and repeatedly with a layer of a second material comprising a ternary Group III-V material, thus making the multi-layer stack.

In embodiments, the binary Group III-V material may be InP.

In embodiments, the ternary Group III-V material may be InGaAs or GaAsSb.

In embodiments, the first material and/or the second material may be doped with a dopant element.

In embodiments, the dopant element may be an n-type or a p-type dopant element.

In embodiments, the present invention relates to a method for fabricating a horizontal gate-all-around nanowire field effect transistor comprising forming suspended horizontal nanowires according to embodiments of the first aspect of the present invention. A gate stack may be provided surrounding the suspended horizontal nanowires. This gate stack may comprise a gate insulator and a gate metal provided on the gate insulator.

It is advantageous due to fact that the method allows for forming plurality of horizontal nanowires, particularly more than 2 nanowires having substantially the same diameter, scalable preferably, down to 5 to 7 nm. Thus, it allows for meeting the requirements for achieving the desired device performance as CMOS scaling in on-going. Plurality of horizontal nanowires having substantially the same diameter scalable, preferably, down to 5 to 7 nm provides.

In a **second aspect,** not falling within the scope of the claims, the present disclosure relates to a semiconductor structure. The semiconductor structure comprises a substrate comprising a dielectric layer and a fin structure. This fin structure comprises a portion protruding from the dielectric layer. This protruding portion is partially un-masked thereby comprising a multi-layer stack consisting of a layer of a first material stacked alternately and repeatedly with a layer of a second material. The partially un-masked protruding portion further comprises horizontal nanowires of the second material suspended over a sacrificial layer and at least one of the horizontal nanowires is covered with a cladding layer. This sacrificial layer covers the multi-layer stack, wherein the layers have a non-uniform size.

Thus, there is provided a semiconductor structure advantageously enabling sequential formation of horizontal nanowires. This semiconductor structure is suitable for the manufacture of horizontal gate-all-around nanowire field effect transistors (GAA-FET) comprising plurality of horizontal nanowires, preferably more than 2 nanowires.

In embodiments, the sacrificial layer may be formed as a spin-on-carbon layer.

In embodiments, the diameter of the horizontal nanowires may be substantially the same.

Thus, there is provided a structure advantageously enabling the manufacture of horizontal gate-all-around nanowire field effect transistors (GAA-FET) with improved device performance thanks to the to the plurality of horizontal nanowires having substantially the same diameter.

In embodiments, the diameter of the horizontal nanowires may have a standard deviation of 2 nm

In embodiments, the cladding layer may be a metal.

It advantageous due to the fact that the metal cladding layer allows for resistance during the selective removal of the first layer, thus allowing to maintain diameter of the nanowire.

In embodiments, this metal may be nickel, cobalt or ruthenium.

In preferred embodiments, this metal is nickel.

In alternative embodiments, the cladding layer may be a metal oxide. In embodiments, this metal oxide may be a high-k dielectric material. In embodiments, this high-k dielectric material may be aluminum oxide, hafnium oxide, zinc oxide, zirconium oxide or titanium oxide.

In embodiments, the first material may comprise Si and Ge and the second material may comprise Si.

In embodiments, the first material may comprise SiGe and the second material may comprise Si.

In embodiments, the first material may comprise Si and the second material may comprise Si and Ge.

In embodiments, the first material may comprise Si and the second material may comprise SiGe.

In embodiments, a layer of a first material comprising a binary Group III-V material may be stacked alternately and repeatedly with a layer of a second material comprising a ternary Group III-V material.

In embodiments, the binary Group III-V material may be InP.

In embodiments, the ternary Group III-V material may be InGaAs or GaAsSb.

In embodiments, the first material and/or the second material may be doped with a dopant element.

In embodiments, the dopant element may be an n-type or a p-type dopant element.

### Brief description of the figures

The figures are only schematic and are non-limiting. In the drawings, the size of some of the elements may be exaggerated and not drawn on scale for illustrative purposes. Any reference signs in the claims shall not be construed as limiting the scope. In the different drawings, the same reference signs refer to the same or analogous elements.
**Fig. 1** is a flowchart representing a method according to embodiments of the present invention.
**Fig. 2a** is a flowchart representing formation of the horizontal nanowires.
**Fig. 2b** is a flowchart representing selective removal of the first material according to an embodiment of the present invention.
**Fig. 3** shows schematically a substrate used for the forming of horizontal nanowires according to embodiments of the present invention.
**Fig. 4 (a)** **to** **Fig. 4** **(1)** shows schematically a process flow for forming horizontal nanowires according to embodiments of the present invention.
**Fig. 5** shows schematically a semiconductor structure comprising horizontal nanowires formed by methods according to embodiments of the present invention.
**Fig. 6** shows schematically a semiconductor structure obtained during the formation of horizontal nanowires by methods according to embodiments of the present invention.

### Detailed description of the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

It is to be noticed that the term *"comprising",* used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof.

Reference throughout the specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout the specification are not necessarily all referring to the same embodiment, but may. Furthermore, the particular features, structures or characteristics may be combined in any suitable manner, as would be apparent to one of ordinary skill in the art from the disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. The method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into the detailed description, with each claim standing on its own as a separate embodiment of the invention.

Furthermore, while some embodiments described herein include some but not other features included in other embodiments, combinations of features of different embodiments are meant to be within the scope of the invention, and form different embodiments, as would be understood by those in the art. The scope of the present invention is defined solely by the appended claims.

In the description provided herein, numerous specific details are set forth. However, it is understood that embodiments of the invention may be practiced without these specific details. In other instances, well-known methods, structures and techniques have not been shown in detail in order not to obscure an understanding of the description.

The following terms are provided solely to aid in the understanding of the invention.

As used herein and unless provided otherwise, the term ***"sacrificial layer"*** refers to a layer that is meant to be sacrificed or removed at a certain stage in the process flow.

As used herein and unless provided otherwise, the term ***"suspended"*** refers to released and can be used interchangeably throughout the text.

As used herein and unless provided otherwise, the term ***"spin-*on"** refers to a class of dielectric materials that are deposited by spin-on coating technique.

As used herein and unless provided otherwise, the term ***"cladding layer"*** refers to a layer covering the complete exposed surface of the horizontal nanowire.

As used herein and unless provided otherwise, the term ***"exposed"*** refers to a layer, a surface or a region that is not protected from its surrounding environment.

As used herein and unless provided otherwise, the term **"CD"** refers to critical dimension and indicates the width of the feature in question.

As used herein and unless provided otherwise, the term ***"Self-Assembled Monolayer (SAM)"*** refers to molecular assemblies that form on the surfaces spontaneously by adsorption and are organized into more or less large ordered domains. SAM materials may possess a head group with a strong affinity to the substrate, a tail group and a functional end group. SAM materials are created by the chemisorption of the head groups onto the substrate from vapor or liquid phase followed by slow organization of the tail groups.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

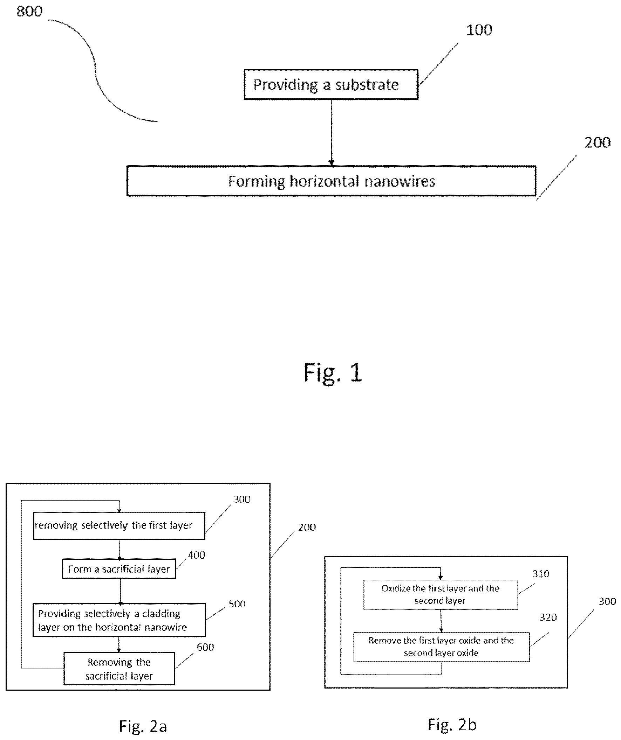

We now refer to **Fig. 1****,** **Fig. 3 and Fig. 4a****.**

**Fig. 1** shows a flowchart representing a method according to embodiments of the present invention.

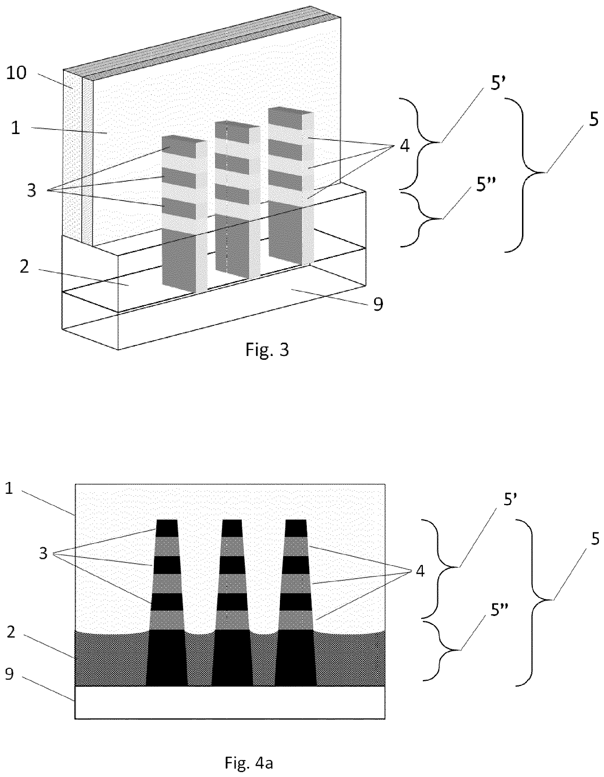

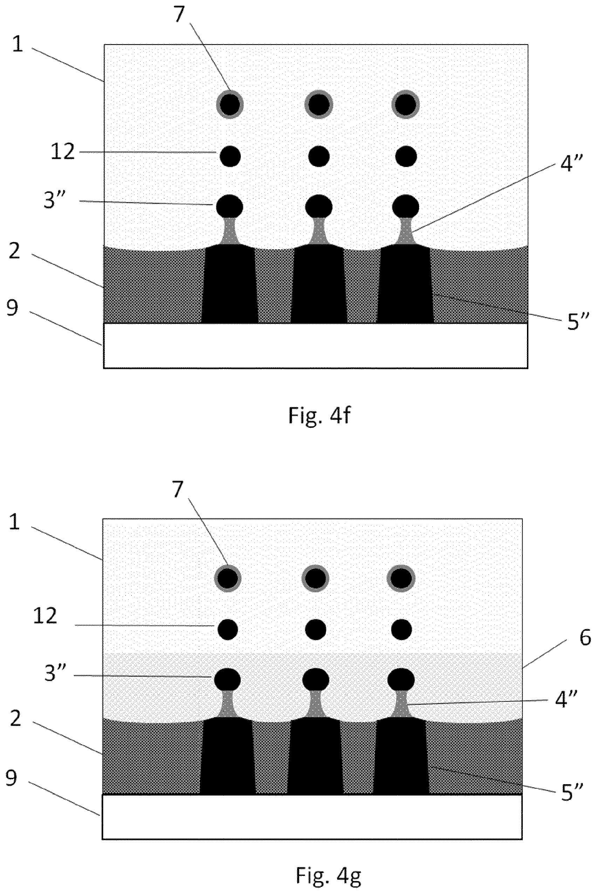

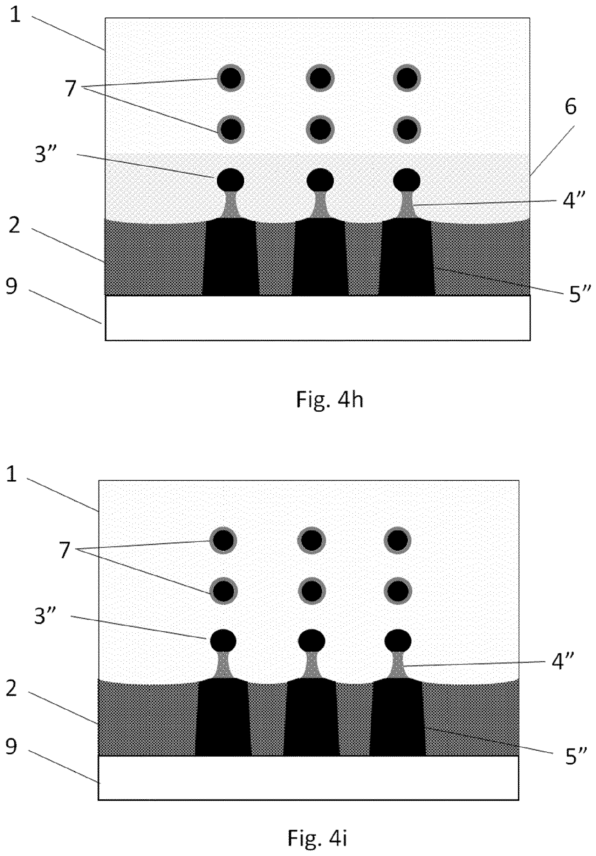

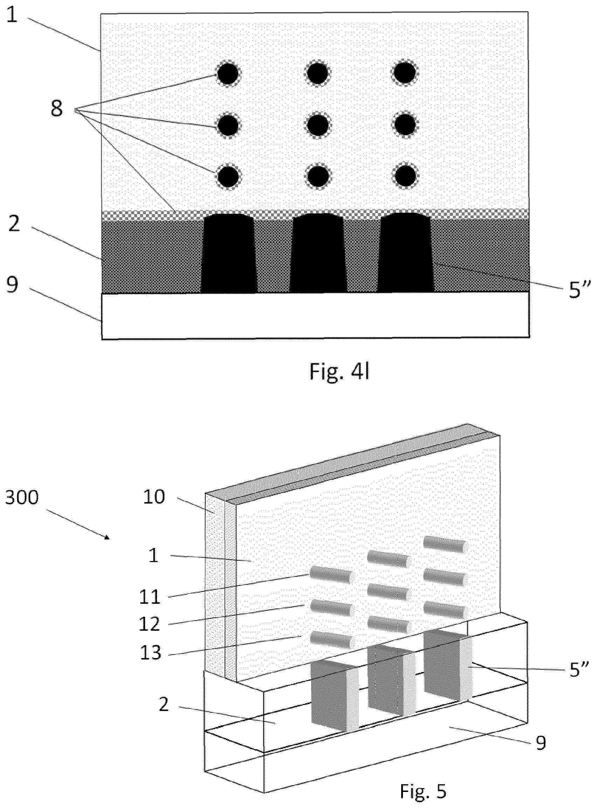

**Fig. 3** shows schematically a substrate (9), tilted and in three dimension, used for the forming of horizontal nanowires according to embodiments of the present invention, and **Fig. 4a** schematically shows cross section of this substrate. The multi-layer stack comprised in the substrate shown in these figures consists of three layers (4) of a first material stacked alternately and repeatedly with three layers (3) of a second material. This should not be construed in any limiting sense such that the multi-layer stack comprised in the substrate may consist of more than two layers of first material stacked alternately and repeatedly with more than two layers of second material. In this way, plurality of horizontal nanowires, greater than two, can be obtained.

The method (800) comprises providing (100) a substrate (9) and forming (200) horizontal nanowires.

The substrate (9) comprises a dielectric layer (2) and a fin structure (5) **(****Fig. 3** and **Fig. 4a****).** In embodiments, the substrate may be a silicon substrate. The substrate (9) may also be a silicon on insulator (SOI) substrate or any substrate suitable for growing fin structures. The dielectric layer (9) may be a silicon oxide layer. The dielectric layer (9) may be referred to as shallow trench isolation (STI) dielectric and may be in direct contact with the substrate (9). The fin structure (5) comprises a portion (5') that protrudes from the dielectric layer (2) and a non-protruding portion (5") that is embedded in the dielectric layer (2). The bottom of the non-protruding portion (5") may lie at the interface between the dielectric layer (2) and the substrate (9). It may also lie above or below this interface. The bottom of the non-protruding portion (5") may be flat or may have V-shape. The protruding portion (5') is partially un-masked and comprises a multi-layer stack. This multi-layer stack consists of a layer (4) of a first material stacked alternately and repeatedly with the layer (3) of a second material.

In embodiments, the first material and/or the second material may be doped with a dopant element. This dopant element may be an n-type or a p-type dopant element. Typically, boron is used as a p-type dopant, while phosphorus or arsenic is used an n-type dopant.

In embodiments, the first material may comprise Si and Ge and the second material may comprise Si.. In these embodiments, the first material may, for example, comprise SiGe and the second material may for example, comprise Si.

Alternatively, in embodiments, the first material may comprise Si and the second material may comprise Si and Ge. In these alternative embodiments, the first material may, for example, comprise Si and the second material may, for example, comprise SiGe.

The fin structure (5) may be obtained after performing several process steps. It may, for example, be obtained by providing a substrate (9) and depositing alternating and repeated layers of the first material and the second material. Further, a fin patterning process may be done in order to form the fin structure (5). Depending on the fin patterning process, a plurality of fin structures may be formed. Providing the dielectric layer (2) may embed the fin structure (5) in this dielectric layer (2). Performing an etch back process of the dielectric layer (2) may lead to the formation of the fin structure (5) comprising a portion protruding from the etch-backed dielectric layer (2), wherein the protruding portion comprises the multi-layer stack. The protruding portion (5') of the fin structure (5) may be covered conformally by a dielectric layer (not shown in the figures). When such a dielectric layer is present, this is typically referred to as a dummy dielectric layer and it needs to be removed from the unmasked protruding portion before forming (200) the nanowires.

Partial masking of the protruding portion (5') is provided by a dielectric layer. This partial masking refers to masking a part of the protruding portion (5') including the top and the sidewalls. This partial masking, thus, creates a partially un-masked portion. In embodiments, this dielectric layer may comprise a first dielectric layer (10) and a second dielectric layer (1) stacked horizontally and in contact with each other.

In embodiments, the first dielectric layer (10) may be a silicon oxide layer while the second dielectric layer (1) may be a silicon nitride layer. The second dielectric layer (1) may be used as spacer.

The protruding portion (5') of the fin structure (5) may be covered conformally by a dielectric layer (not shown in the figures). In the fabrication of horizontal gate-all-around nanowire field effect transistors (GAA-FET), this is typically referred to as a dummy gate dielectric layer. A dummy gate dielectric layer and a dummy gate may be used when fabricating the GAA-FET through Replacement Metal Gate (RMG) approach and it needs to be removed from the unmasked protruding portion before forming (200) the nanowires.

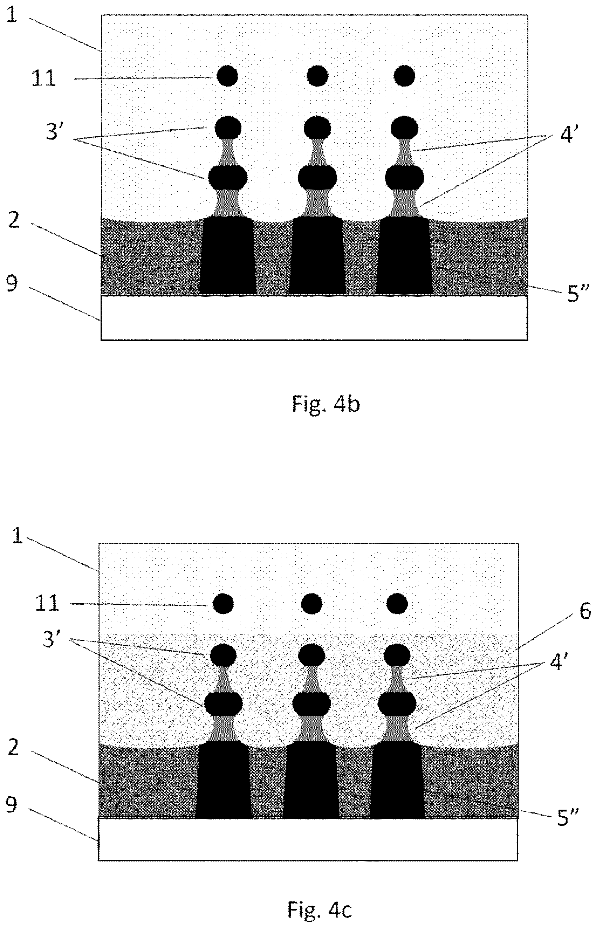

We now refer to **Fig. 2a****,** showing a flowchart representing a method for forming (200) of the horizontal nanowires, while referring also to **Fig. 4(b)** to **Fig. 4(l)** showing corresponding cross-sections of the substrate at different stages of the method. Purely to facilitate understanding, different layers, even of the same material, are shown with different numbers, however; this should not be construed in any limiting sense.

Formation of the horizontal nanowires is done by performing a cycle **(****Fig. 2a****).** This cycle comprises removing (300) selectively the first material. The first material is removed selectively up to the moment that a horizontal nanowire of the second material becomes suspended over a remaining portion of the partially unmasked protruding portion (5'). The horizontal nanowires become suspended starting from the top. Thus, as shown in **Fig. 4b****,** the top nanowire (11) of the second material becomes suspended during the first cycle.

According to the invention, selective removal (300) of the first material comprises oxidizing (310) the first material and the second material. An etching process is performed, whereby parameters of the etching process is chosen to remove the oxide of the first material faster than the oxide of the second material (320) **(****Fig. 2b****).** This selective removal process comprising oxidation and etching, may be cyclic repeated up to the moment that that a horizontal nanowire of the second material becomes suspended over a remaining portion of the partially un-masked protruding portion.

In embodiments, this etching process may be a dry plasma etching process.

This dry plasma etching process is advantageous since the first material and the second material get both oxidized during the oxidation process. The rate of oxidation or the thickness of the oxide of the first material and the second material may depend on the oxidation kinetics of the first and the second material. This dry plasma etching process, thus, allows for formation of the horizontal nanowire with a desired diameter or in other words with a desired CD, by allowing for the removal of the oxide of the first material faster than the oxide of the second material. Furthermore, in the making of CMOS devices, one of the devices, either p-MOS or n-MOS needs to be protected by a photoresist layer during processing to make the n-MOS or the p-MOS. Thus, dry plasma etching is further advantageous since the photoresist layer is compatible with dry etching process.

The oxidation and the etching process done during the selective removal may also result in material loss of the other layers of the first material of the multi-layer stack **(****Fig. 4b****),** thus allowing them to end up with a non-uniform size (4') compared to their initial size (4). In the meantime, the other layers of the second material also end up with a non-uniform size (3') compared to their initial size (3) **(****Fig. 4b****).**

In alternative embodiments, the first material may comprise a binary Group III-V material and the second material may comprise a ternary Group III-V material.

In these alternative embodiments, the selective removal may comprise performing a wet etching process. The wet etching process may remove the binary Group III-V material, which is the first material.

In these alternative embodiments, the wet etching process may be done by using a wet etchant comprising hydrogen chloride.

In these alternative embodiments, the wet etchant may consist of water and hydrogen chloride. This wet etchant is advantageous since it allows for etching the binary Group III-nitride material selective towards the ternary Group III-nitride material.

In these alternative embodiments, the binary Group III-V material may be InP.

In these alternative embodiments, the ternary Group III-V material may be InGaAs or GaAsSb. Thus, this wet etchant will allow advantageously to etch InP selective towards InGaAs or GaAsSb.

In these alternative embodiments, this first material and/or this second material may be doped with a dopant element.

In these alternative embodiments, the dopant element may be an n-type or a p-type dopant element.

In these alternative embodiments, when the fin structure (5) has a tapered profile, the provision of the cladding layer (7) presents the advantage of protecting the already formed suspended horizontal nanowire, while the size of the following suspended nanowire is being tuned according to the size of this already formed suspended nanowire. This is due to the fact that the use of the wet etchant will only allow to remove the layer of the first material, which may be InP, selective to the layer of the second material, which may be InGaAs or GaAsSb, thereby forming the following horizontal nanowire. However, for tuning its size, it will be necessary to etch this horizontal nanowire. This may be done by performing a dry plasma etching process, whereby protection of the horizontal nanowire already formed becomes necessary during the dry plasma etching process.

A sacrificial layer (6) is formed (400) on the partially unmasked protruding portion **(****Fig. 2a** and **Fig. 4c****)** except for the suspended horizontal nanowire (11). This sacrificial layer (6) leaves the suspended horizontal nanowire uncovered. Thus, when this sacrificial layer is formed after the formation of the top horizontal nanowire (11) during the first cycle of the formation of the horizontal nanowires, the first suspended horizontal nanowire, which is the top one, is left uncovered.

In embodiments, the substrate (9) may be rotated along an axis perpendicular to a main surface of the substrate (9) during the formation of the sacrificial layer. Rotation allows for homogeneous distribution of the sacrificial layer (6) over the surface and allows for control of its thickness by adjusting the rotation speed. Adjustment of the thickness of the sacrificial layer (6) allows to let the suspended horizontal nanowire to remain un-covered, while allowing to let the remaining portion uniformly covered. Furthermore, it allows for providing freedom on the thickness for the provision of the cladding layer (7) on the suspended horizontal nanowire.

According to the invention, the sacrificial layer is a spin-on material and is self-planarizing.

Due to the fact that the sacrificial layer is formed after the horizontal nanowire becomes suspended, a further modification of the size of the suspended nanowire is undesired. A self-planarizing spin-on material has the advantage that it avoids creation of topography, while covering the remaining portion of the partially un-masked protruding portion. Absence of topography has the advantage that material removal processes becomes obsolete, thus avoiding the suspended nanowire becoming subjected to etch-back process to remove topography, which would otherwise jeopardize the diameter of the suspended horizontal nanowire.

In embodiments, the sacrificial layer may be formed as a spin-on-carbon layer. SOC is a self-planarizing layer and is able to cover the remaining portion without topography issues. SOC layer is easy to remove from the substrate, thus, does not pose a challenge on the distortion of the profile of the partial masking dielectric layer. This dielectric layer may comprise a first dielectric layer (10) and a second dielectric layer (1) stacked horizontally and in contact with each other. This partial masking dielectric layer may be used in the fabrication of horizontal gate-all-around nanowire field effect (GAA-FET) transistors and damaging may result in exposure of the gate electrode leading to electrical shorting of the gate electrode with the source or the drain region after establishing the electrical contact.

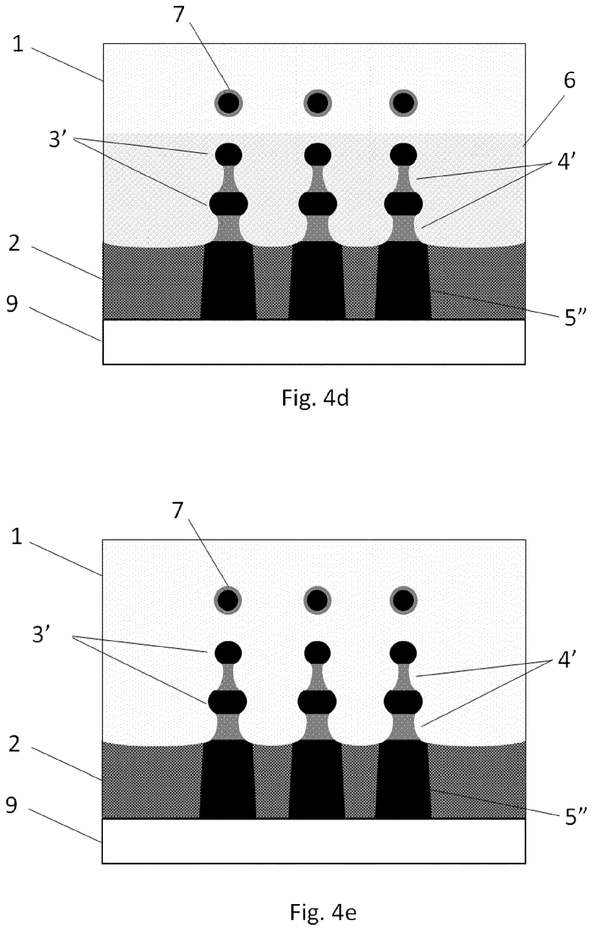

A cladding layer (7) is provided (500) on the suspended horizontal nanowire (11) **(****Fig. 2a** and **Fig. 4d****).** The cladding layer (7) covers the complete surface of the suspended horizontal nanowire (11).

The purpose of the cladding layer (7) is to protect the already formed suspended horizontal nanowire (11) during the selective removal of the first material that will be take place in a subsequent cycle to be performed for the formation of the subsequent horizontal nanowire. Therefore, the provision of a cladding layer (7) provides maintaining the size of the suspended horizontal nanowire during the formation of the subsequent horizontal nanowires.

Furthermore, the provision of the cladding layer provides an opportunity for increasing the number of cycles in the cyclic selective removal (300) (Fig. 2b) of the first material for the formation of subsequent horizontal nanowires, by protecting the already formed suspended horizontal nanowire. Considering the fact that the profile of the fin structure (5) may be tapered such that the width gets larger moving from its top to its bottom, necessitates extended number of cycles in the cyclic selective removal in order to achieve the size of horizontal nanowire that is protected by the cladding layer.

In embodiments, the cladding layer may be a metal.

In embodiments, the cladding layer may be Ni, Co or Ru.

In preferred embodiments, the cladding layer may be Ni. Use of Ni is advantageous since it protects the already formed horizontal nanowire towards the selective removal of the first material during the formation of the subsequent nanowires through selective removal.

In alternative embodiments, the cladding layer (7) may be a metal oxide. This metal oxide may be a high-k dielectric material. This high-k dielectric material may be aluminum oxide, hafnium oxide, zinc oxide, zirconium oxide or titanium oxide. Using a metal oxide cladding layer is advantageous due to the fact that it is not affected by cyclic selective removal process that is carried out for the formation of the horizontal nanowire.

In embodiments, selective provision of the cladding layer (7) may be done by electro-less deposition or by an Atomic Layer Deposition (ALD) process. Electro-less deposition or ALD process is advantageous since conformal, uniform cladding layer may be deposited with controlled thickness. In embodiments, the provision of the cladding layer (7) may further comprise first removal of the native oxide from the surface of the layer (4) of the first material and the layer (3) of the second material. This native oxide removal may be done by a treatment using diluted hydrogen fluoride (HF). Removal of the native oxide by diluted HF treatment makes the surface of the nanowires become H-terminated.

In embodiments where the suspended horizontal nanowires are doped with a dopant element, provision of the cladding layer (7) by electro-less deposition may be advantageous. In these embodiments, removal of the native oxide from the surface of the layer (4) of the first material and the layer (3) of the second material is advantageous for the efficiency of the electro-less deposition of the cladding layer Removal of the native oxide may be done by performing a diluted HF treatment. Using electro-less deposition for the provision of the cladding layer (7) is advantageous when the layer of the second material is Si-comprising. Thus, when the suspended horizontal nanowires are made of doped Si, for example, it will be advantageous to use electro-less deposition for the provision of the cladding layer (7). In these embodiments, the cladding layer (7) may be nickel, cobalt or ruthenium.In embodiments, provision of the cladding layer (7) may comprise application of a self-assembled monolayer (SAM) (not shown in the figures). Self-assembled monolayer may be applied as an inhibition layer on the exposed surfaces of the first dielectric layer (10) and the second dielectric layer (1), but not on the exposed sacrificial layer (6), thereby facilitating easy and direct provision of the cladding layer on the suspended horizontal nanowire. When SAM is used as the inhibition layer, the choice of SOC as the sacrificial layer (6) provides a further advantage such that it is immune to the SAM layer, and thus, the SAM layer will not be deposited on the SOC sacrificial layer (6).

When the SAM layer is used as an inhibition layer, provision of the cladding layer (7) may be done by electro-less deposition or ALD process. In embodiments, where the layer of the second material is Si-comprising, using electro-less deposition is advantageous. Thus, when the suspended horizontal nanowires are made of doped Si, for example, it will be advantageous to use electro-less deposition for the provision of the cladding layer (7) comprising the application of a self-assembled monolayer (SAM). In these embodiments, the cladding layer (7) may be nickel, cobalt or ruthenium.

In embodiments, when ALD process is used for the provision of the metal cladding layer (7) comprising the application of the SAM layer, the cladding layer (7) may be nickel, cobalt or ruthenium and the second material may comprise Si or may comprise ternary Group III-V material.

Alternatively, in these embodiments, where ALD is process is used, the cladding layer (7) may also be a metal oxide, which may be aluminum oxide, hafnium oxide, zinc oxide, zirconium oxide or titanium oxide. The metal oxide may be directly provided as metal oxide by the ALD process. Alternatively, metal of the metal oxide may be provided by the ALD process, which then may be followed by oxidation of this metal to thereby obtain the metal oxide cladding layer (7).

In embodiments, where the suspended horizontal nanowires are not doped with a dopant element, provision of the cladding layer (7) may still be done by electro-less deposition. This may be achieved by the use of a second SAM layer that may be provided on the on the H-terminated nanowires thanks to the removal of the native oxide by the diluted HF treatment. Provision of the second SAM layer makes it possible for the cladding layer to be deposited on the nanowires.

In these embodiments, the layer of the second material may comprise Si. Thus, the suspended horizontal nanowires may be made of doped Si.

Before the selective removal of the first material starts in the subsequent cycle for forming the subsequent horizontal nanowire, the sacrificial layer (6) is removed (600) from the remaining portion **(****Fig. 2a** **and** **Fig. 4e****).** Removal of the sacrificial layer may be done by performing a dry plasma etching process using an oxygen plasma. This oxygen plasma does not damage the exposed surfaces of the substrate (9). Furthermore, since the already suspended horizontal nanowire (11) is covered by the cladding layer (7), it is also protected and thus, its size is maintained. Removal of the sacrificial layer (6) thus, completes the first cycle of the formation of horizontal nanowires, whereby the top nanowire is formed **(****Fig. 4e****).**

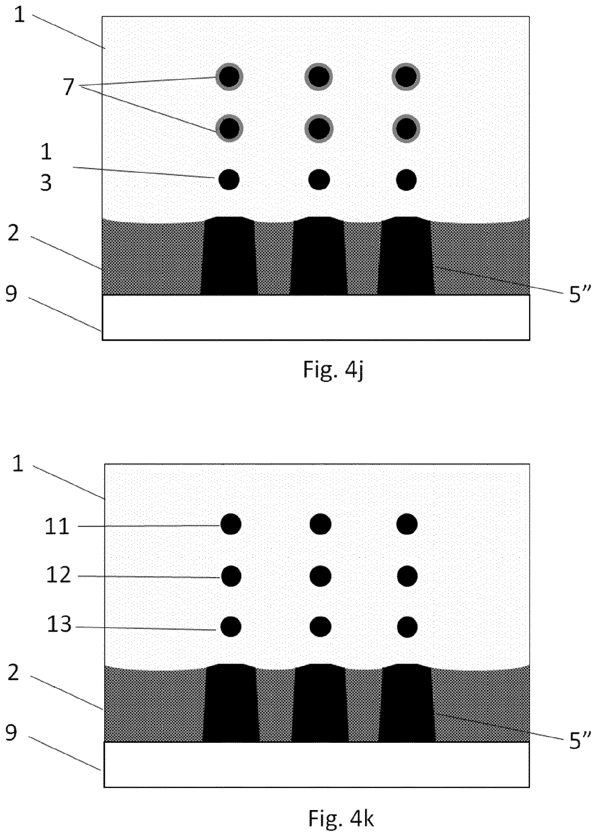

**Fig. 4f** to **Fig. 4i** schematically show how another cycle is completed to form the subsequent horizontal nanowire, where this subsequent nanowire is also covered selectively with the cladding layer (7) at the end of this another cycle. Applying a final cyclic selective removal of the first material from the remaining portion of the partially un-masked protruding portion leads to the formation of the bottom horizontal nanowire. This final cyclic selective removal also provides tuning the size of the bottom horizontal nanowire in line with the size of the previously formed ones. After the formation of this bottom horizontal nanowire **(****Fig. 4j****),** the cladding layer (7) covering the previously formed horizontal nanowires is removed **(****Fig. 4k****).** Horizontal nanowires are formed, whereby they substantially have the same diameter. Having substantially the same diameter or size may refer to the fact that the diameter of the horizontal nanowires may have a standard deviation of 2 nm.

The (desired) diameter of the horizontal nanowires is determined as a function of the technology node in CMOS manufacturing. The control of the diameter of the horizontal nanowires is achieved by the cyclic selective removal process. Its verification may be done by performing a cross section scanning electron microscopy (X-SEM) or transmission electron microscopy (TEM) .

Removal of the cladding layer (7) may be done by performing a wet etching process. This wet etching process may be done by using HCl.

The masked portion of the protruding portion (5') of the fin structure (5) is protected against the selective removal during the formation of suspended horizontal nanowires (11, 12, 13). Thus, even after the formation of the suspended horizontal nanowires (11, 12, 13), the layer of the first material and the layer of the second material of the multi-layer stack is present as being stacked alternately and repeatedly with each other.

In embodiments, the present invention relates to a method for fabricating a horizontal gate-all-around nanowire field effect transistor (GAA-FET). The method may comprise forming suspended horizontal nanowires (11,12,13) according to embodiments of the first aspect of the present invention **(****Fig. 4k** and **Fig. 5****).** A gate stack (8) may be provided that surrounds the suspended horizontal nanowires (11,12,13) **(****Fig. 41****).** This gate stack may comprise a gate insulator and a gate metal provided on the gate insulator. This gate insulator may be a high-k dielectric layer. This gate metal may be a gate metal stack comprising also layers dedicated for effective work function tuning.

In these embodiments, when the first material comprises Si and Ge and the second material comprises Si, the fabricated horizontal GAA nanowire FET will be a n-MOS device. This is due to the fact that selective removal of the first material will result in the formation of horizontal nanowires comprising Si.

On the other hand, when the first material comprises Si and the second material comprises Si and Ge, the fabricated horizontal GAA nanowire FET will be an p-MOS device. This is due to the fact that selective removal of the first material will result in the formation of horizontal nanowires comprising Si and Ge.

Similarly, when the multi-layer stack of the layer of first material comprising the binary Group III-V material stacked alternately and repeatedly with the layer of the second material comprising a ternary Group III-V material is used, the fabricated horizontal GAA nanowire FET will be a p-MOS device or an n-MOS device after removal of the binary Group III-V material, which may be InP. When the layer of the second material comprises InGaAs, the resulting horizontal GAA nanowire FET will be an n-MOS device, while it will be a p-MOS device if the second material comprises GaAsSb.

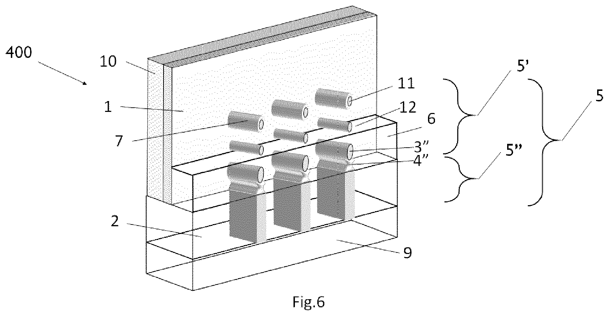

We now refer to **Fig. 6** that shows schematically a semiconductor structure (400) according to a **second aspect** of the present disclosure which does not fall within the scope of the claims.

The semiconductor structure (400) comprises a substrate (9) comprising a dielectric layer (2) and a fin structure (5). The fin structure (5) comprises a portion (5') protruding from the dielectric layer (2). The protruding portion is partially unmasked thereby comprising a multi-layer stack. The multi-layer stack consists of a layer (4) of a first material stacked alternately and repeatedly with a layer (3) of a second material. The partially un-masked protruding portion further comprises horizontal nanowires (11, 12) of the second material suspended over a sacrificial layer (6) and at least one of the horizontal nanowires (11) is covered with a cladding layer (7). The sacrificial layer (6) covers the multi-layer stack, whereby layers (4") of the first material stacked alternately and repeatedly with layers of the second material (3"). The layers (3", 4") have a non-uniform size. By non-uniform size it is meant that the size of the layers (3", 4") are not in agreement with each other. The partially masked portion of the protruding portion (5') has the multi-layer stack, whereby the alternating layers (3, 4) have uniform size.

In embodiments, the sacrificial layer (6) may be a spin-on-carbon layer.

This semiconductor structure is advantageous due to the fact that it allows sequential formation of plurality of horizontal nanowires. It is, therefore, further advantageous for the manufacturing of horizontal gate-all-around nanowire field effect transistors (GAA-FET).

In embodiments, the bottom of the non-protruding portion (5") may lie at the interface between the dielectric layer (2) and the substrate (9). It may also lie above or below this interface. The bottom of the non-protruding portion (5") may be flat or may have V-shape.

Partial masking of the protruding portion (5') is provided by a dielectric layer. This partial masking refers to masking a part of the protruding portion (5') including the top and the sidewalls. This partial masking, thus, creates a partially un-masked portion. In embodiments, this dielectric layer may comprise a first dielectric layer (10) and a second dielectric layer (1) stacked horizontally and in contact with each other.

In embodiments, the first dielectric layer (10) may be a silicon oxide layer while the second dielectric layer (1) may be a silicon nitride layer.

In embodiments, diameter of the horizontal nanowires (11, 12) may be substantially the same.

Thus, the semiconductor structure allows sequential formation of plurality of horizontal nanowires having substantially the same diameter. It is, therefore, advantageous for the manufacturing of horizontal gate-all-around nanowire field effect transistors (GAA-FET) with improved device performance thanks to the plurality of horizontal nanowires having substantially the same diameter. In horizontal gate-all-around nanowire field effect transistors (GAA-FET), current is transferred through each of these nanowires. Having substantially the same diameter, thus, allows for reducing distortions in current flow, thereby improving device performance.

In embodiments, the cladding layer (7) may be a metal.

The presence of the cladding layer (7) is an indication that the horizontal nanowire has the desired diameter and thus, its presence is advantageous since it maintains the size of the horizontal nanowire.

In embodiments, this metal may be Ni, Co or Ru.

In preferred embodiments, this metal is Ni.

In alternative embodiments, the cladding layer (7) may be a metal oxide. This metal oxide may be a high-k dielectric material. This high-k dielectric material may be aluminum oxide, hafnium oxide, zinc oxide, zirconium oxide or titanium oxide.

In embodiments, the first material may comprise Si and Ge and the second material may comprise Si. In these embodiments, the first material may comprise SiGe, while the second material may comprise Si.

In alternative embodiments, the first material may comprise a binary Group III-V material and the second material may comprise a ternary Group III-V material.

In these alternative embodiments, the binary Group III-V material may be InP.

In these alternative embodiments, the ternary Group III-V material may be InGaAs or GaAsSb.

In embodiments, this first material and/or this second material may be doped with a dopant element.

In embodiments, the dopant element may be an n-type or a p-type dopant element.

## Claims

1. A method for forming horizontal nanowires, the method comprising:
- providing a substrate (9) comprising a dielectric layer (2) and a fin structure (5) comprising a protruding portion (5') protruding from the dielectric layer (2), the protruding portion comprising a multi-layer stack consisting of a layer (4) of a first material stacked alternately and repeatedly with a layer (3) of a second material, the bottom layer of the multilayer stack being a layer (4) of the first material,
- masking a part of the protruding portion (5') including the top and the sidewalls thereof by providing a dielectric layer (1, 10) thereby creating an un-masked portion of the protruding portion, and
- sequentially forming horizontal nanowires (11, 12, 13) starting from the top of the un-masked portion, wherein the forming is done by repeatedly performing a cycle comprising:
- removing selectively the first material from the un-masked portion up to the moment that a horizontal nanowire of the second material becomes suspended over a remaining portion of the unmasked portion (5'),
- forming a sacrificial layer (6) on the remaining portion, while leaving the suspended horizontal nanowire uncovered,
- providing, selectively, a cladding layer (7) on the uncovered suspended horizontal nanowire, and thereafter
- removing the sacrificial layer (6),
the method further comprising:
- forming a bottom horizontal nanowire by removing selectively the first material from the bottom layer of the un-masked portion up to the moment that the bottom horizontal nanowire of the second material becomes suspended,
- removing the cladding layer (7) covering the previously formed horizontal nanowires, wherein the sacrificial layer (6) is a spin-on material and is self-planarizing and wherein the selective removal of the first material is cyclic and comprises:
- oxidizing the first material and the second material, and
- performing an etching process, whereby parameters of the etching process are chosen to remove the oxide of the first material faster than the oxide of the second material.

2. The method according to claim 1, wherein the substrate (9) is rotated during the formation of the sacrificial layer.

3. The method according to claim 1, wherein, the sacrificial layer (6) is formed as a spin-on-carbon layer.

4. The method according to claim 1, wherein the etching process is a dry plasma etching process.

5. The method according to any one of preceding claims, wherein the cladding layer (7) is a metal.

6. The method according to any one of preceding claims, wherein providing, selectively, the cladding layer (7) comprises performing an electro-less deposition or an atomic layer deposition.

7. The method according to any one of the preceding claims, wherein the first material comprises Si and Ge, and the second material comprises Si.

8. The method according to any of the preceding claims, wherein the first material comprises Si and the second material comprises Si and Ge.

9. A method for fabricating a horizontal gate-all-around nanowire field effect transistor, comprising:
- forming suspended horizontal nanowires (11, 12, 13) according to any of the claims 1 to 8, and;
- providing a gate stack (8), surrounding the suspended horizontal nanowires (11, 12, 13), comprising a gate insulator and a gate metal provided on the gate insulator.

## Patentansprüche

1. Verfahren zur Herstellung von horizontalen Nanodrähten, wobei das Verfahren umfasst:
- Bereitstellen eines Substrats (9), das eine dielektrische Schicht (2) und eine Rippenstruktur (5) umfasst, die einen vorstehenden Abschnitt (5') umfasst, der von der dielektrischen Schicht (2) vorsteht, wobei der vorstehende Abschnitt einen mehrschichtigen Stapel umfasst, der aus einer Schicht (4) aus einem ersten Material besteht, die abwechselnd und wiederholt mit einer Schicht (3) aus einem zweiten Material gestapelt ist, wobei die unterste Schicht des mehrschichtigen Stapels eine Schicht (4) aus dem ersten Material ist,
- Maskieren eines Teils des vorstehenden Abschnitts (5') einschließlich der Oberseite und der Seitenwände desselben durch Bereitstellen einer dielektrischen Schicht (1, 10), wodurch ein nicht maskierter Abschnitt des vorstehenden Abschnitts geschaffen wird, und
- sequentielles Bilden von horizontalen Nanodrähten (11, 12, 13), beginnend von der Oberseite des unmaskierten Abschnitts, wobei das Bilden durch wiederholtes Durchführen eines Zyklus erfolgt, der Folgendes umfasst:
- selektives Entfernen des ersten Materials von dem nicht maskierten Teil bis zu dem Moment, in dem ein horizontaler Nanodraht des zweiten Materials über einem verbleibenden Teil des nicht maskierten Teils (5') abgehängt wird,
- Bilden einer Opferschicht (6) auf dem verbleibenden Teil, wobei der aufgehängte horizontale Nanodraht unbedeckt bleibt,
- selektives Anbringen einer Mantelschicht (7) auf dem unbedeckten aufgehängten horizontalen Nanodraht und danach
- Entfernen der Opferschicht (6),
das Verfahren weiter umfassend:
- Bilden eines unteren horizontalen Nanodrahtes durch selektives Entfernen des ersten Materials von der unteren Schicht des nicht maskierten Teils bis zu dem Moment, in dem der untere horizontale Nanodraht aus dem zweiten Material abgehängt wird,
- Entfernen der Mantelschicht (7), die die zuvor gebildeten horizontalen Nanodrähte bedeckt, wobei die Opferschicht (6) ein Aufschleudermaterial ist und sich selbst planarisiert und wobei das selektive Entfernen des ersten Materials zyklisch erfolgt und Folgendes umfasst:
- Oxidieren des ersten Materials und des zweiten Materials, und
- Durchführung eines Ätzprozesses, wobei die Parameter des Ätzprozesses so gewählt werden, dass das Oxid des ersten Materials schneller entfernt wird als das Oxid des zweiten Materials.

2. Verfahren nach Anspruch 1, wobei das Substrat (9) während der Bildung der Opferschicht gedreht wird.

3. Verfahren nach Anspruch 1, wobei die Opferschicht (6) als Spin-on-Carbon-Schicht gebildet ist.

4. Verfahren nach Anspruch 1, wobei das Ätzverfahren ein TrockenplasmaÄtzverfahren ist.

5. Verfahren nach einem der vorstehenden Ansprüche, wobei die Mantelschicht (7) ein Metall ist.

6. Verfahren nach einem der vorstehenden Ansprüche, wobei das selektive Bereitstellen der Mantelschicht (7) die Durchführung einer elektrolytlosen Abscheidung oder einer Atomlagenabscheidung umfasst.

7. Verfahren nach einem der vorstehenden Ansprüche, wobei das erste Material Si und Ge umfasst und das zweite Material Si umfasst.

8. Verfahren nach einem der vorstehenden Ansprüche, wobei das erste Material Si und das zweite Material Si und Ge umfasst.

9. Verfahren zur Herstellung eines horizontalen Gate-all-around-Nanodraht-Feldeffekttransistors, umfassend:
- Bilden von abgehängten horizontalen Nanodrähten (11, 12, 13) nach einem der Ansprüche 1 bis 8 und;
- Bereitstellen eines Gate-Stapels (8), der die abgehängten horizontalen Nanodrähte (11, 12, 13) umgibt und einen Gate-Isolator und ein auf dem Gate-Isolator vorgesehenes Gate-Metall umfasst.

## Revendications

1. Procédé de formation de nanofils horizontaux, le procédé comprenant :
- une fourniture d'un substrat (9) comprenant une couche diélectrique (2) et une structure d'ailette (5) comprenant une portion saillante (5') faisant saillie à partir de la couche diélectrique (2), la portion saillante comprenant un empilement multicouche consistant en une couche (4) d'un premier matériau empilée alternativement et de manière répétée avec une couche (3) d'un second matériau, la couche du dessous de l'empilement multicouche étant une couche (4) du premier matériau,
- un masquage d'une partie de la portion saillante (5') incluant le dessus et les parois latérales de celle-ci en fournissant une couche diélectrique (1, 10) créant ainsi une portion non masquée de la portion saillante, et
- une formation de manière séquentielle de nanofils horizontaux (11, 12, 13) en commençant par le dessus de la portion non masquée, dans lequel la formation est réalisée en accomplissant de manière répétée un cycle comprenant :
- un retrait de manière sélective du premier matériau de la portion non masquée jusqu'au moment où un nanofil horizontal du second matériau devient suspendu au-dessus d'une portion restante de la portion non masquée (5'),
- une formation d'une couche sacrificielle (6) sur la portion restante, tout en laissant le nanofil horizontal suspendu non couvert,
- une fourniture, de manière sélective, d'une couche de gainage (7) sur le nanofil horizontal suspendu non couvert, et par la suite
- un retrait de la couche sacrificielle (6),
le procédé comprenant en outre :
- une formation d'un nanofil horizontal du dessous en retirant de manière sélective le premier matériau de la couche du dessous de la portion non masquée jusqu'au moment où le nanofil horizontal du dessous du second matériau devient suspendu,
- un retrait de la couche de gainage (7) couvrant les nanofils horizontaux formés au préalable, dans lequel la couche sacrificielle (6) est un matériau déposé par rotation et est auto-planarisante et dans lequel le retrait sélectif du premier matériau est cyclique et comprend :
- une oxydation du premier matériau et du second matériau, et
- un accomplissement d'un processus de gravure, selon lequel des paramètres du processus de gravure sont choisis pour retirer l'oxyde du premier matériau plus rapidement que l'oxyde du second matériau.

2. Procédé selon la revendication 1, dans lequel le substrat (9) tourne durant la formation de la couche sacrificielle.

3. Procédé selon la revendication 1, dans lequel la couche sacrificielle (6) est formée comme une couche de carbone déposé par rotation.

4. Procédé selon la revendication 1, dans lequel le processus de gravure est un processus de gravure au plasma.

5. Procédé selon l'une quelconque des revendications précédentes, dans lequel la couche de gainage (7) est un métal.

6. Procédé selon l'une quelconque des revendications précédentes, dans lequel une fourniture, de manière sélective, de la couche de gainage (7) comprend un accomplissement d'un dépôt autocatalytique ou d'un dépôt de couche atomique.

7. Procédé selon l'une quelconque des revendications précédentes, dans lequel le premier matériau comprend du Si et du Ge, et le second matériau comprend du Si.

8. Procédé selon l'une quelconque des revendications précédentes, dans lequel le premier matériau comprend du Si et le second matériau comprend du Si et du Ge.

9. Procédé de fabrication d'un transistor à effet de champ à nanofils à grille enrobante horizontaux, comprenant :
- une formation de nanofils horizontaux (11, 12, 13) suspendus selon l'une quelconque des revendications 1 à 8, et ;
- une fourniture d'un empilement de grille (8), entourant les nanofils horizontaux (11, 12, 13) suspendus, comprenant un isolant de grille et un métal de grille fourni sur l'isolant de grille.
